(19) Europäisches Patentamt
European Patent Office
Office européen des brevets

(11) EP 2 237 339 A2

(12) **EUROPEAN PATENT APPLICATION**

(43) Date of publication:
**06.10.2010 Bulletin 2010/40**

(51) Int Cl.:
***H01L 51/42*** *(2006.01)* ***H01G 9/20*** *(2006.01)*

(21) Application number: **10156235.3**

(22) Date of filing: **11.03.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA ME RS**

(30) Priority: **30.03.2009 JP 2009080924**

(71) Applicant: **TDK Corporation**
**Tokyo 103-8272 (JP)**

(72) Inventors:
- **Handa, Tokuhiko**
  **Chuo-ku Tokyo 103-8272 (JP)**
- **Monden, Atsushi**
  **Chuo-ku Tokyo 103-8272 (JP)**

(74) Representative: **Grünecker, Kinkeldey, Stockmair & Schwanhäusser Anwaltssozietät**
**Leopoldstrasse 4**
**80802 München (DE)**

(54) **Electrode for photoelectric conversion elements, manufacturing method of the same, and dye-sensitized solar cell**

(57) An electrode for photoelectric conversion elements having high initial characteristics and excellent durability, a manufacturing method of the electrode for photoelectric conversion elements, and a dye-sensitized solar cell are provided. An electrode for photoelectric conversion elements 11 according to the present invention has a structure in which a metal oxide layer 14 containing zinc oxide is provided on a base 12. The metal oxide layer 14 has a plurality of bump-like protrusions 14a formed so as to protrude radially from the base 12 side, and also has an emission peak in a region of 350 to 400 nm in cathodoluminescence measurement. The metal oxide layer is preferably heat treated at 220 to 500˚C.

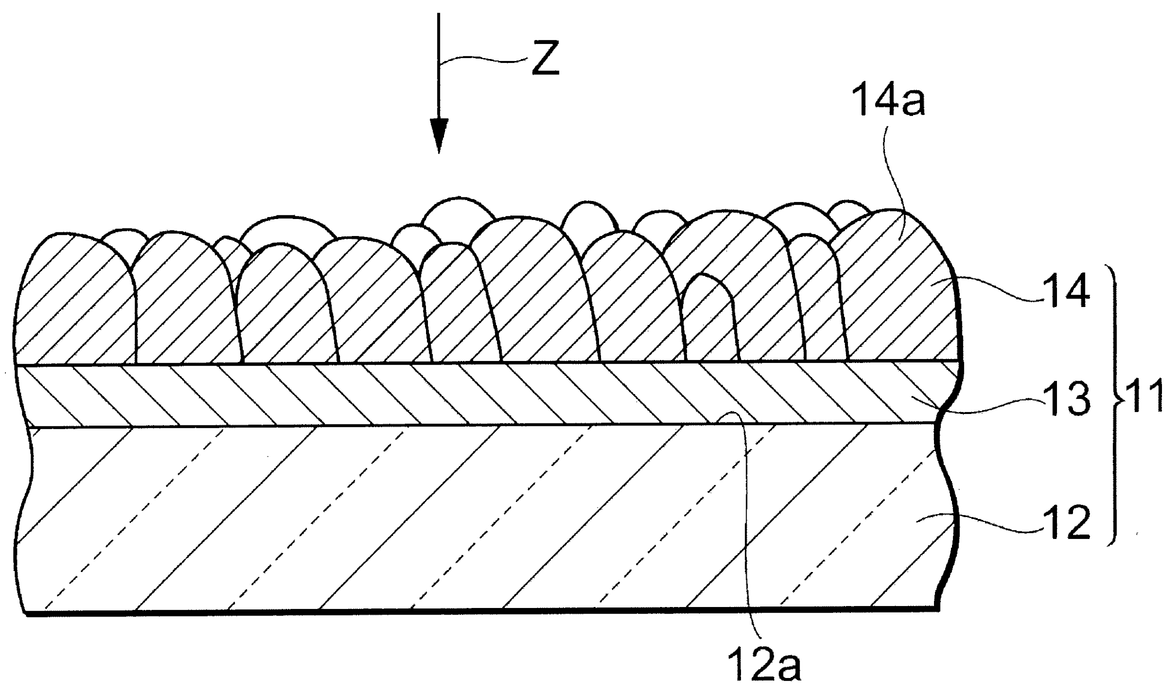


*FIG. 1*

EP 2 237 339 A2

Printed by Jouve, 75001 PARIS (FR)

**Description**

BACKGROUND OF THE INVENTION

Field of the Invention

The present invention relates to an electrode for photoelectric conversion elements, a manufacturing method of the electrode for photoelectric conversion elements, and a dye-sensitized solar cell including the electrode for photoelectric conversion elements.

Description of the Related Art

In recent years, solar photovoltaic power generation has received attention as one of promising means for solving environmental problems as typified by exhaustion of fossil fuel resources and reduction of carbon dioxide emissions. As typical examples of solar cells for such solar photovoltaic power generation, single-crystalline and polycrystalline silicon-based solar cells have already been put on the market and are widely known. In this technical field, however, fears of short supply of silicon as a main raw material are growing recently, and practical utilization of a non-silicon-based solar cell (e.g., $CuInGaSe_2$ (CIGS) or the like) of the next generation is much desired.
As such a non-silicon-based solar cell, a dye-sensitized solar cell published by Gratzel et al. in 1991 has especially received attention as an organic solar cell capable of realizing conversion efficiency of 10% or more. Recently, application, development, and research of the dye-sensitized solar cell are actively performed in various research organizations at home and abroad.
For example, as an electrode (working electrode) of the dye-sensitized solar cell, a structure in which zinc oxide is electrolytically deposited from a zinc nitrate electrolyte solution containing eosin Y onto a transparent conductive film of a transparent glass substrate is known (see Patent Document 1). It is also known that enhanced photoelectric conversion efficiency can be attained by desorbing eosin Y through an alkaline treatment of porous zinc oxide co-adsorbed with eosin Y and then re-adsorbing the dye to zinc oxide (see Patent Document 2).
Meanwhile, it is known that an electrode having cathodoluminescence characteristics that an emission peak wavelength exists in a visible light region and also having a haze ratio of 60% or more in visible light region wavelength is obtained by applying a suspension of semiconductor particles such as $TiO_2$ and ZnO onto a substrate and then firing it (see Patent Document 3).
On the other hand, as a technique which is not based on electrolytic deposition, it is known that a ZnO whisker film having photoluminescence characteristics in the visible light region is obtained by adding ammonia, amines, or the like to a zinc acetate aqueous solution to deposit zinc oxide and accumulating this zinc oxide on a substrate (see Patent Document 4).
[Patent Document 1] Japanese Patent Application Laid-Open No. 2002-184476

[Patent Document 2] Japanese Patent Application Laid-Open No. 2004-006235

[Patent Document 3] Japanese Patent Application Laid-Open No. 2003-217689

[Patent Document 4] Japanese Patent Application Laid-Open No. 2008-230895

However, in the case where the electrode manufactured according to electrolytic deposition as described in Patent Documents 1 and 2 is used as a working electrode of a photoelectric conversion element (e.g., a dye-sensitized solar cell), though initial characteristics (photoelectric conversion efficiency immediately after manufacture) are relatively high, there is significant performance degradation with time and so durability (reliability) is insufficient. In the case where the electrode manufactured according to the method of firing semiconductor particles as described in Patent Document 3 is used as a working electrode of a photoelectric conversion element, though durability is relatively high, initial characteristics are insufficient. Meanwhile, the ZnO whisker film formed by the aqueous solution process as described in Patent Document 4 has an insufficient performance evaluation as a working electrode of a photoelectric conversion element, and also is considered to be far off from practical utilization in photoelectric conversion element application that requires high photoelectric conversion efficiency because ZnO whiskers (particles) generated by anisotropically growing a crystal in a c-axis direction are accumulated in a state of lying on the substrate.

SUMMARY OF THE INVENTION

The present invention has been developed in view of such a situation. An object of the present invention is to provide an electrode for photoelectric conversion elements having high initial characteristics and excellent durability, a manufacturing method of the electrode for photoelectric conversion elements, and a dye-sensitized solar cell.

As a result of repeating intensive study in order to solve the stated problems, the present inventors have found that, in a metal oxide layer containing zinc oxide formed by electrolytic deposition, not only crystallinity which is a bulk property but also surface state characterization has a significant correlation with initial characteristics and durability, and completed the present invention.

That is, an electrode for photoelectric conversion elements according to the present invention includes: a base; and a metal oxide layer containing zinc oxide, wherein the metal oxide layer has a plurality of bump-like protrusions formed so as to protrude radially from a side of the base, and also has an emission peak in a region of 350 to 400 nm in cathodoluminescence measurement. Note that stoichiometry of "zinc oxide" in this specification is not limited to ZnO (x=1 and y=1 in $Zn_xO_y$).

As a result of measuring characteristics of a dye-sensitized solar cell in which a working electrode obtained by adsorbing (carrying) a dye on the electrode for photoelectric conversion elements of the above-mentioned structure is disposed so as to face a counter electrode and a charge transport layer is provided therebetween, the present inventors have found that the dye-sensitized solar cell has high initial characteristics and excellent durability. Though details of a functional mechanism that contributes to such effects are still unclear, for example the following presumption can be made.

According to findings of the present inventors, a metal oxide layer (zinc oxide film) having a plurality of bump-like (pinecone-like in some cases) protrusions formed so as to protrude radially from the base side is considered to have a bulk property of high crystallinity as detected by X-ray diffraction analysis and the like, but also have many crystal defects such as oxygen defects on its film surface. In the case where such a metal oxide layer is used as a working electrode of a photoelectric conversion element by making the metal oxide layer carry a dye, the dye carrying metal oxide layer functions as an n-type oxide semiconductor with excellent electron transportability due to the bulk property, so that high photoelectric conversion efficiency is delivered immediately after manufacture. However, the oxygen defects unevenly distributed on the film surface cause significant performance degradation with time, which makes it impossible to achieve high photoelectric conversion efficiency over a long period of time. On the other hand, the metal oxide layer (zinc oxide film) of the above-mentioned structure not only has high bulk crystallinity but also has an emission peak of cathodoluminescence in a region of 350 to 400 nm as derived from a band gap of zinc oxide, with there being few crystal defects on the film surface. Hence, the metal oxide layer of the above-mentioned structure effectively functions as an electrode for photoelectric conversion elements (a precursor of a working electrode of a photoelectric conversion element) having high initial characteristics and excellent durability. Note, however, that the function is not limited to such. As described later, it has been confirmed that the plurality of bump-like protrusions of zinc oxide according to the present invention are grown so that each protrusion protrudes individually whereas no such bump-like protrusions are formed on a conventional zinc oxide film of high crystallinity, and thus they have a significant difference in, for example, sectional shape.

It is preferable that the metal oxide layer is heat treated at 220 to 500˚C. By heat treating the metal oxide layer containing zinc oxide at 220 to 500˚C, the metal oxide layer having an emission peak in the region of 350 to 400 nm in cathodoluminescence measurement can be obtained easily with high reproducibility, which contributes to enhanced productivity and economic efficiency. Note that, in the case of a zinc oxide electrode formed by conventional electrolytic deposition, a heat treatment at a high temperature (220 to 500˚C) seems to be not intended at all because of a manufacturing advantage of omitting a high temperature firing process which is needed in manufacture of titanium oxide electrodes.

Here, it is preferable that the metal oxide layer satisfies a relation defined by the following formula (1)

$$2 \leq I_{002}/I_{101} \qquad \cdots (1)$$

where $I_{002}$ denotes a peak intensity attributed to a zinc oxide (002) face in X-ray diffraction measurement of the metal oxide layer, and $I_{101}$ denotes a peak intensity attributed to a zinc oxide (101) face in the X-ray diffraction measurement. Typically, it is considered that higher crystallinity of zinc oxide as a bulk property leads to enhanced electron transportability. Especially in the case where the metal oxide layer is used as a working electrode of a photoelectric conversion element by causing a dye to be adsorbed (carried) on the metal oxide layer, a dye adsorption (carrying) amount tends to be insufficient if a c-axis orientation of zinc oxide is excessively low. Accordingly, by increasing the c-axis orientation, i.e., the crystallinity of zinc oxide of the metal oxide layer so as to satisfy the relation defined by the above formula (1), it is possible to increase the dye adsorption amount.

It is more preferable that the metal oxide layer is heat treated after being formed by electrolytic deposition. In this way, the metal oxide layer having high crystallinity with few crystal defects on its film surface can be realized at low cost with high reproducibility.

Moreover, a dye-sensitized solar cell according to the present invention includes: a working electrode in which a dye is carried by the electrode for photoelectric conversion elements described above; a counter electrode disposed so as to face the working electrode; and a charge transport layer disposed between the working electrode and the counter electrode.

Furthermore, a manufacturing method of an electrode for photoelectric conversion elements according to the present invention includes: a step of preparing an electrode in which a metal oxide layer containing zinc oxide is provided on a base, the metal oxide layer having bump-like protrusions formed so as to protrude radially from a side of the base; and a step of heat treating the metal oxide layer at 220 to 500˚C to form the metal oxide layer having an emission peak in a region of 3 50 to 400 nm in cathodoluminescence measurement. By causing a dye to be adsorbed (carried) on the metal oxide layer of the electrode for photoelectric conversion elements, a working electrode of a dye-sensitized solar cell can be manufactured. In this specification, the meaning of "a metal oxide layer is provided on a base" includes not only a mode where the metal oxide layer is directly provided on the base but also a mode where the metal oxide layer is provided on the base via an intermediate layer. Therefore, particular embodiments of the present invention include both a laminate structure in which the base and the metal oxide layer are disposed in direct contact with each other as in the former case and a laminate structure in which the base and the metal oxide layer are disposed apart from each other as in the latter case.

Here, it is preferable that, in the step of preparing the electrode, the base and a counter electrode are disposed so as to face each other in an electrolyte solution of a dye concentration of 50 to 500 $\mu$M containing zinc salt and a first dye and a voltage of -0.8 to -1.2 V (vs. Ag/AgCl) is applied between the base and the counter electrode to form a composite layer in which the dye is co-adsorbed to zinc oxide, and subsequently the dye is desorbed from the composite layer, thereby forming the metal oxide layer.

According to the present invention, a high-performance electrode for photoelectric conversion elements having high initial characteristics and excellent durability can be realized easily at low cost. Moreover, since stable output is maintained over a long period of time, an extended product life cycle of the photoelectric conversion element can be attained. This benefits resource conservation.

BRIEF DESCRIPTION OF THE DRAWINGS

FIG. 1 is a schematic sectional view schematically showing an embodiment of the electrode for photoelectric conversion elements;

FIG. 2 is a schematic sectional view schematically showing an embodiment of a dye-sensitized solar cell;

FIG. 3 is X-ray diffraction data of the electrodes for photoelectric conversion elements of Example 3 and Comparative Example 1;

FIG. 4 is a sectional SEM photograph of the electrode for photoelectric conversion elements of Example 1;

FIG. 5 is a sectional SEM photograph of the electrode for photoelectric conversion elements of Comparative Example 3;

FIG. 6 is cathodoluminescence measurement data of metal oxide layers of the electrodes for photoelectric conversion elements of Examples 1 to 4 and Comparative Examples 1 and 2; and

FIG. 7 is cathodoluminescence measurement data of metal oxide layers of the electrode for photoelectric conversion elements of Comparative Examples 3 and 4.

DESCRIPTION OF THE PREFERRED EMBODIMENTS

The following describes embodiments of the present invention. Note that the same elements are given the same reference numerals and redundant description is omitted. Moreover, positional relations such as top, bottom, left, and right are based on the positional relations shown in the drawings, unless otherwise specified. Furthermore, dimensional ratios of the drawings are not limited to the illustrated ratios. Note also that the following embodiments are merely examples for describing the present invention, and the present invention is not limited to the embodiments.

(First Embodiment)

FIG. 1 is a schematic sectional view schematically showing an embodiment of an electrode for photoelectric conversion elements according to the present invention. An electrode for photoelectric conversion elements 11 in this

embodiment has a structure in which a porous metal oxide layer 14 containing zinc oxide formed by electrolytic deposition is provided on a base 12 having a conductive surface 12a. The metal oxide layer 14 has a plurality of bump-like protrusions 14a formed so as to protrude radially from the base side, and also has an emission peak in the region of 350 to 400 nm in cathodoluminescence measurement. Though a dye-sensitized solar cell is described as an example of a photoelectric conversion element in this embodiment, the photoelectric conversion element is not limited to such.

A size and shape of the base 12 are not particularly limited so long as the base 12 is capable of supporting at least the metal oxide layer 14. For instance, a plate-like base or a sheet-like base is preferably used. Specific examples of the base 12 include a glass substrate, a plastic substrate such as polyethylene terephthalate, polyethylene, polypropylene, and polystyrene, a metal substrate, an alloy substrate, a ceramic substrate, and a laminate of these substrates. The base 12 preferably has transparency, and more preferably has excellent transparency in the visible light region. Furthermore, the base 12 preferably has flexibility. Such flexibility allows structures of various forms to be provided.

A technique of forming the conductive surface 12a by imparting conductivity to the surface of the base 12 is not particularly limited. For example, a method of using the base 12 having conductivity, a method of forming a transparent conductive film on the base 12 like a conductive PET film, and the like are applicable. The transparent conductive film in the latter method is not particularly limited, but ITO, $SnO_2$, $InO_3$, FTO obtained by doping $SnO_2$ with fluorine, or the like is preferably used. A formation method of such a transparent conductive film is not particularly limited, either. A known technique such as evaporation, CVD, spraying, spin coating, and immersion is applicable. A film thickness of the transparent conductive film can be set appropriately.

An intermediate layer 13 may be provided between the conductive surface 12a and the metal oxide layer 14, as shown in FIG. 1. The intermediate layer 13 preferably has transparency. Furthermore, the intermediate layer 13 preferably has conductivity. A material of the intermediate layer 13 is not particularly limited. Examples of the material include zinc oxide, and the metal oxides described with regard to the above-mentioned transparent conductive film. Alternatively, the intermediate layer 13 may be omitted.

The metal oxide layer 14 is a porous semiconductor layer that is substantially made of zinc oxide. Here, "substantially made of zinc oxide" means to contain zinc oxide as a main component, where an oxide of zinc having a composition ratio that is stoichiometrically different from zinc oxide (ZnO) in a precise sense may be contained and also, for example, zinc hydroxide as an unavoidable component, an unavoidable impurity such as a small amount of other metal salt or hydrate, and the like may be contained.

The metal oxide layer 14 has the plurality of bump-like protrusions 14a formed so as to radially protrude (grow) outward (upward in the drawing) from the conductive surface 12a side of the base 12. Such a peculiar structure has a large adsorption site amount of a dye to be co-adsorbed and also enables the co-adsorbed dye to be desorbed and re-adsorbed with high efficiency, and therefore can be suitably used as a working electrode of a dye-sensitized solar cell. Note that the property of this metal oxide layer 14 can be observed by sectional SEM photography, sectional TEM photography, and so on.

The metal oxide layer 14 has an emission peak in the region of 350 to 400 nm in cathodoluminescence measurement. "Cathodoluminescence" referred to here is an emission phenomenon that occurs when an electron-hole pair, which is generated by applying an accelerated electron beam to a surface of a metal oxide in a vacuum, recombines. Information about crystal defects and impurities can be obtained by this cathodoluminescence measurement. Cathodoluminescence has various advantages when compared with photoluminescence whereby an excitation occurs in the visible to ultraviolet light region. For example, since it is possible to narrow a beam diameter to about several 10 nm, a microscopic region can be evaluated, and also an emission distribution can be viewed in a two-dimensional image. Moreover, it is possible to vary a penetration depth of the electron beam from about 0.1 $\mu$m to several $\mu$m by changing an acceleration voltage of the electron beam, so that information about an emission center in a depth direction can be obtained. Furthermore, a wide gap semiconductor that is difficult to excite in the visible to ultraviolet light region can be evaluated. As described later, there are cases where a notable difference is shown in cathodoluminescence even though there is almost no difference in bulk crystal evaluation such as X-ray diffraction (XRD). This is considered to particularly represent a difference such as the presence or absence of crystal defects or impurities near a material surface.

The metal oxide layer 14 having the above-mentioned profile can be obtained with high reproducibility, by performing a treatment such as a heat treatment, a pressurized oxygen treatment, a UV ozone treatment, and an oxygen plasma treatment on the metal oxide layer 14 made of zinc oxide. For example, the metal oxide layer 14 made of zinc oxide formed by electrolytic deposition usually has an emission peak in the visible light region (400 to 700 nm) but does not have an emission peak in the region of 350 to 400 nm in cathodoluminescence measurement. Performing the above-mentioned treatment, however, enables the metal oxide layer 14 to have an emission peak in this region, too. As a result, durability can be enhanced. Note that, in this specification, "cathodoluminescence measurement" is assumed to be conducted under conditions described with regard to below-mentioned Examples.

Here, the metal oxide layer 14 preferably satisfies a relation defined by the following formula (1).

$$2 \leq I_{002}/I_{101} \qquad \cdots (1)$$

where $I_{002}$ denotes a peak intensity attributed to a zinc oxide (002) face in X-ray diffraction measurement of the metal oxide layer 14 (the metal oxide layer 14 and the intermediate layer 13 in the case where the intermediate layer 13 is made of the same material as the metal oxide layer 14. The same applies to both $I_{002}$ and $I_{101}$ hereafter), and $I_{101}$ denotes a peak intensity attributed to a zinc oxide (101) face in the same X-ray diffraction measurement.

The metal oxide layer 14 whose peak intensity ratio is in the range defined by the above formula (1) not only has a feature of high crystallinity as a bulk property, but also tends to be excellent in terms of dye adsorption (carrying) amount. When the peak intensity ratio $I_{002}/I_{101}$ is less than 2, in the case of using the metal oxide layer 14 as a working electrode of a dye-sensitized solar cell, a problem of a lack of electron collection ability, more specifically, a decrease in $J_{SC}$, tends to arise. Though an upper limit of the peak intensity ratio is not particularly limited, from a viewpoint of achieving a proper porosity for excellent dye replaceability, the upper limit is preferably not more than 100, more preferably not more than 30, and still more preferably not more than 12. When the peak intensity ratio exceeds 30, a problem such as a decrease in $J_{SC}$ caused by an insufficient dye carrying amount tends to arise.

As shown in FIG. 1, the above-mentioned X-ray diffraction measurement is performed from a direction (z-arrow direction in the drawing) perpendicular to an extending surface of the base 12. The peak intensity ratio $I_{002}/I_{101}$ is one of indexes such that the c-axis orientation is weak when the ratio is small and the c-axis orientation is strong when the ratio is large. Typically, in polycrystalline zinc oxide in powder form, the intensity $I_{101}$ of the diffraction peak of the (101) face shows a maximum diffraction intensity, and the peak intensity ratio $I_{002}/I_{101}$ is less than 1, usually about 0.1 to 0.5.

A film thickness of the metal oxide layer 14 is not particularly limited, but is preferably 1 to 15 $\mu$m, and more preferably 2 to 10 $\mu$m. When the film thickness is less than 1 $\mu$m, in the case of using the metal oxide layer 14 as a working electrode of a dye-sensitized solar cell, an insufficient dye carrying amount may cause a decrease in short-circuit photoelectric current ($J_{SC}$). When the film thickness exceeds 15 $\mu$m, there are problems such as a lack of film strength and a decrease in fill factor (ff).

A manufacturing method of the electrode for photoelectric conversion elements 11 in this embodiment is described below. The electrode for photoelectric conversion elements 11 is manufactured through a step of preparing the base 12, a step of forming the intermediate layer 13 on the base 12, a step of forming the metal oxide layer 14, and a step of performing a treatment such as the above-mentioned heat treatment, pressurized oxygen treatment, UV ozone treatment, and oxygen plasma treatment on the formed metal oxide layer 14.

First, conductivity is imparted to one surface of the base 12 using the above-mentioned appropriate method, to form the conductive surface 12a. In the case of using the base 12 having conductivity beforehand such as a metal plate as the base 12, the step of imparting conductivity is unnecessary. Next, prior to the formation of the intermediate layer 13, an appropriate surface modification treatment is performed on the conductive surface 12a of the base 12 as necessary. Specific examples of the treatment include a known surface treatment such as a degreasing treatment with a surfactant, an organic solvent, an aqueous alkaline solution, or the like, a mechanical polishing treatment, an immersion treatment in an aqueous solution, a preliminary electrolysis treatment with an electrolyte solution, a washing treatment, and a drying treatment.

The intermediate layer 13 is formed, for example, by depositing or accumulating zinc oxide or any of the metal oxides described with regard to the above-mentioned transparent conductive film, on the conductive surface 12a of the base 12 according to a known technique such as evaporation, CVD, spraying, spin coating, immersion, and electrolytic deposition.

Next, the metal oxide layer 14 is formed on the intermediate layer 13. A method of forming the metal oxide layer 14 by electrolytic deposition is described below as an example, though the formation method of the metal oxide layer 14 is not limited to this. First, a composite layer (dye carrying semiconductor layer) containing zinc oxide and a first dye is formed, and then the dye is desorbed from the composite layer to prepare the metal oxide layer 14. In more detail, the intermediate layer 13 of the base 12 and a counter electrode are disposed so as to face each other in an electrolyte solution containing zinc salt and the first dye, and a predetermined voltage is applied between the intermediate layer 13 of the base 12 and the counter electrode using a reference electrode according to an ordinary method, thereby electrolytically depositing a composite layer (composite structure) in which the dye is co-adsorbed to the surface of zinc oxide. The dye is then desorbed from the composite layer.

As the electrolyte solution, an aqueous solution of a pH of about 4 to 9 containing the first dye and the zinc salt to be co-adsorbed is preferably used. A small amount of organic solvent may be added to this electrolyte solution. The zinc salt is not particularly limited, as long as the zinc salt serves as a zinc ion source capable of supplying zinc ions in the solution. For example, zinc halides such as zinc chloride, zinc bromide, and zinc iodide, zinc sulfate, zinc acetate, zinc peroxide, zinc phosphate, zinc pyrophosphate, and zinc carbonate are preferably used. A zinc ion concentration in the electrolyte solution is preferably 0.5 to 100 mM, and more preferably 2 to 50 mM.

An electrolysis method is not particularly limited, and any of a two-electrode system and a three-electrode system is applicable. As an energization system, a direct current may be supplied, or a constant potential electrolysis process or a pulse electrolysis process may be used. As the counter electrode, platinum, zinc, gold, silver, graphite, or the like may be used according to an ordinary method. Of these, zinc and platinum are preferably used.

A reduction electrolysis potential is preferably in a range of -0.8 to -1.2 V (vs. Ag/AgCl), and more preferably in a range of -0.9 to -1.1 V (vs. Ag/AgCl). With this range of reduction electrolysis potential, the metal oxide layer 14 of high crystallinity having the plurality of bump-like protrusions 14a can be effectively formed. Moreover, the metal oxide layer 14 that satisfies the relation defined by the above formula (1) and has a porous structure with excellent dye replaceability and a large dye carrying amount can be obtained easily with high reproducibility. When the reduction electrolysis potential exceeds -0.8 V, the film becomes denser than necessary, causing a problem such as an insufficient dye carrying amount. When the reduction electrolysis potential is less than -1.2 V, there are problems such as a decrease in electric property as the oxide becomes more metallic and degradation in film adhesiveness. In the case where the electrolyte solution contains zinc halide, to promote an electrolytic deposition reaction of zinc oxide by reduction of dissolved oxygen in the aqueous solution, it is preferable to sufficiently introduce required oxygen by, for example, bubbling oxygen. A bath temperature of the electrolyte solution can be set in a wide range in consideration of a heat resistance of the base 12 used. Typically, the bath temperature is preferably 0 to 100˚C, and more preferably about 20 to 90˚C.

Since the first dye for use in this electrolytic deposition step is co-adsorbed according to cathode electrolytic deposition, the first dye is preferably dissolved or dispersed in the electrolyte solution. In the case where an aqueous solution of a pH of about 4 to 9 containing the zinc salt is used as the electrolyte solution, the first dye is preferably a water-soluble dye.

From a viewpoint of increasing the dye carrying amount, the first dye is preferably a water-soluble dye having an adsorptive group such as a carboxyl group, a sulfonic group, or a phosphoric group that interacts with the surface of zinc oxide. Specific examples of the first dye include a xanthene-based dye such as eosin Y, a coumarin-based dye, a triphenylmethane-based dye, a cyanine-based dye, a merocyanine-based dye, a phthalocyanine-based dye, a porphyrin-based dye, and a polypyridine metal complex dye.

A dye concentration in the electrolyte solution is preferably in a range of 50 to 500 $\mu$M, and more preferably in a range of 70 to 300 $\mu$M. When the dye concentration is less than 50 $\mu$M, the film becomes denser than necessary, causing a problem such as an insufficient dye carrying amount. When the dye concentration exceeds 500 $\mu$M, the density of the film decreases more than necessary, equally causing a problem such as an insufficient dye carrying amount.

As a result of the above-mentioned electrolytic deposition, the composite layer (dye carrying semiconductor layer) in which the first dye is co-adsorbed to the surface of zinc oxide is obtained. Such a composite layer is a structure having the plurality of bump-like protrusions 14a formed so that a crystal of zinc oxide to which the dye is adsorbed protrudes radially from the base 12 surface side, where the plurality of bump-like protrusions 14a define a concavo-convex shape on the surface. The composite layer obtained in this way is then preferably subject to a known post-treatment such as washing and drying according to an ordinary method as necessary.

Next, the first dye is desorbed from the composite layer described above. Thus, the metal oxide layer 14 is prepared. A desorption treatment of the first dye is not particularly limited, as a known technique can be appropriately adopted. For example, a simple technique of immersing the composite layer containing the first dye in an aqueous alkaline solution of a pH of about 9 to 13 such as sodium hydroxide or potassium hydroxide is applicable. As the aqueous alkaline solution, a conventionally known solution may be used, which can be appropriately selected in accordance with the type of the first dye to be desorbed.

In the desorption treatment of the first dye, it is desirable to desorb preferably 80% or more of the first dye and more preferably 90% or more of the first dye in the composite layer. Though an upper limit of a desorption ratio of the first dye is not particularly limited, the upper limit is approximately 99%, given that it is in fact difficult to completely desorb the first dye incorporated in the zinc oxide crystal. Moreover, the desorption treatment is preferably performed under heat, as it can effectively improve desorption efficiency. The obtained metal oxide layer 14 is then preferably subject to a known post-treatment such as washing and drying according to an ordinary method as necessary.

Subsequently, by performing a treatment such as a heat treatment, a pressurized oxygen treatment, a UV ozone treatment, and an oxygen plasma treatment on the metal oxide layer 14 obtained in the above-mentioned manner, the metal oxide layer 14 having an emission peak in the region of 350 to 400 nm in cathodoluminescence measurement is manufactured. The heat treatment is performed preferably at 220 to 500˚C, and more preferably at 300 to 450˚C. A treatment time is not particularly limited, but is preferably about 10 minutes to 1 hour. There is a tendency that a higher treatment temperature contributes to higher durability. Meanwhile, the pressurized oxygen treatment is preferably performed at several MPa for about 1 to 5 days, the UV ozone treatment is preferably performed for about 1 to 30 minutes, and the oxygen plasma treatment is preferably performed at a treatment pressure of 1 to 50 Pa and several 100 W for about 10 minutes to 1 hour.

The electrode for photoelectric conversion elements 11 obtained in this way is an electrode that has excellent

dye replaceability and inherently has a large dye carrying amount, and so can be suitably used as a precursor of a photoelectric conversion element. That is, by re-adsorbing (carrying) a second dye on the metal oxide layer 14 of the electrode for photoelectric conversion elements 11, a photoelectric conversion element having high initial characteristics and excellent durability can be realized.

The re-adsorption of the second dye is not particularly limited, as a known technique can be appropriately adopted. For example, a simple technique of immersing the metal oxide layer 14 in a dye containing solution containing the second dye to be re-adsorbed is applicable. A solvent of the dye containing solution used here can be appropriately selected from known solvents such as water, an ethanol-based solvent, and a ketone-based solvent, according to solubility, compatibility, and the like of the second dye used.

As the second dye to be re-adsorbed, a dye having a desired photoabsorption band and absorption spectrum can be appropriately selected according to performance required as a photoelectric conversion element. By using a sensitizing dye of high sensitivity, it is possible to improve performance as a photoelectric conversion element.

The second dye is not limited by the type of electrolyte solution, unlike the first dye described earlier. Other than the above-mentioned water-soluble dye, for example, a non-water-soluble dye or an oil-soluble dye can be used by appropriately selecting the solvent for use in the dye containing solution. In addition to the dyes exemplified with regard to the first dye to be co-adsorbed, specific examples of the second dye include a ruthenium bipyridinium-based dye, an azo dye, a quinone-based dye, a quinonimine-based dye, a quinacridone-based dye, a squarium-based dye, a cyanine-based dye, a merocyanine-based dye, a triphenylmethane-based dye, a xanthene-based dye, a porphyrin-based dye, a coumarin-based dye, a phthalocyanine-based dye, a perylene-based dye, an indigo-based dye, and a naphthalocyanine-based dye. From a viewpoint of re-adsorbing to the metal oxide layer 14, the second dye preferably has an adsorptive group such as a carboxyl group, a sulfonic group, or a phosphoric group that interacts with the surface of zinc oxide.

After this, a known post-treatment such as washing and drying is performed according to an ordinary method as necessary. A photoelectric conversion element obtained as a result is a composite structure in which the second dye is adsorbed to the surface of zinc oxide, and can be suitably used as a photoelectric conversion element (electrode) having a large dye carrying amount and enhanced photoelectric conversion efficiency.

(Second Embodiment)

FIG. 2 is a schematic sectional view schematically showing an embodiment of a dye-sensitized solar cell according to the present invention. A dye-sensitized solar cell 31 (solar cell) includes, as a photoelectric conversion electrode (element), a working electrode 32 in which the second dye is re-adsorbed (carried) on the metal oxide layer 14 of the electrode for photoelectric conversion elements 11 described in the first embodiment. The dye-sensitized solar cell 31 includes this working electrode 32, a counter electrode 33 disposed so as to face the working electrode 32, and a charge transport layer 34 disposed between the working electrode 32 and the counter electrode 33.

The counter electrode 33 has its conductive surface 33a facing the metal oxide layer 14 to which the second dye is adsorbed. A known electrode may be appropriately adopted as the counter electrode 33. For example, a structure in which a conductive film is provided on a transparent substrate, a structure in which a film of metal, carbon, a conductive polymer, or the like is further formed on the conductive film of the transparent substrate, and the like are applicable, as in the case of the base 12 having the conductive surface 12a in the electrode for photoelectric conversion elements 11 described earlier.

As the charge transport layer 34, a layer typically used in batteries, solar cells, and the like may be appropriately used. Examples of this include a redox electrolyte solution, a semi-solid electrolyte obtained by gelation of the redox electrolyte solution, and a film formed of a p-type semiconductor solid hole transport material.

In the case of using the solution-based or semi-solid-based charge transport layer 34, an electrolyte can be enclosed in a sealed space defined by separating the working electrode 32 and the counter electrode 33 via a spacer or the like not illustrated and sealing the periphery of the structure, according to an ordinary method. Typical examples of the electrolyte solution in the dye-sensitized solar cell include a propylene carbonate solution, an ethylene carbonate solution, a nitrile-based solution such as acetonitrile including iodine and iodide or bromine and bromide, and a mixture of these solutions. Furthermore, an electrolyte concentration, various additives, and the like can be appropriately set and selected according to required performance. For example, a halide, an ammonium compound, or the like may be added.

[Examples]

The following describes the present invention in detail by way of Examples, though the present invention is not limited to such.

(Examples 1 to 4)

An electrode for photoelectric conversion elements having the same structure as the electrode for photoelectric conversion elements 11 shown in FIG. 1 was manufactured according to the following procedure. First, as a base, a transparent glass substrate (TCO: manufactured by Asahi Glass Co., Ltd.) having a transparent conductive film of $SnO_2$ doped with fluorine was disposed so as to face a Pt electrode as a counter electrode in 0.1 M of a KCl electrolyte solution (using pure water of 18 MΩ or less), and preliminary electrolysis was performed while bubbling $O_2$ at 0.3 L/min. At this time, electrolysis conditions were a potential of -1.1 V (vs. Ag/AgCl) and a total coulomb amount of -2.35 C. The preliminary electrolysis was intended to modify the electrolyte solution and the substrate surface by reduction of dissolved oxygen contained in the electrolyte solution.

Next, the counter electrode was changed to a Zn electrode, and 0.13 M of a $ZnCl_2$ aqueous solution was added to the electrolyte solution to set a Zn concentration to 2.5 mM. After this, by performing cathode electrolytic deposition, zinc oxide was deposited on the transparent conductive film of the transparent glass substrate, thereby forming an intermediate layer. At this time, electrolysis conditions were a potential of - 1.2 V (vs. Ag/AgCl) and a total coulomb amount of -0.25 C.

Following this, eosin Y (first dye) was added (180 μM in dye concentration), and then cathode electrolysis was performed to form a composite layer which is a composite structure of zinc oxide and eosin Y on the intermediate layer. At this time, electrolysis conditions were a potential of -0.9 V (vs. Ag/AgCl) and a total coulomb amount of -1.2 C.

An electrode obtained as a result was washed and dried, and then immersed in a KOH aqueous solution of a pH of 11.5 for eight hours to desorb eosin Y in the composite layer, thereby preparing a metal oxide layer. Subsequently, the metal oxide layer was again washed with pure water and dried.

The electrode obtained in the above-mentioned manner was left for 30 minutes in a heater (in air, under atmospheric pressure) set to a temperature shown in Table 1 in order to heat treat the metal oxide layer. As a result, electrodes for photoelectric conversion elements of Examples 1 to 4 were obtained.

(Comparative Example 1)

The same process as Example 1 was performed except that no heat treatment was performed, thereby obtaining an electrode for photoelectric conversion element of Comparative Example 1.

(Comparative Example 2)

The same process as Example 1 was performed except that the treatment temperature was set to 150˚C, thereby obtaining an electrode for photoelectric conversion elements of Comparative Example 2.

(Comparative Example 3)

The same process as Example 1 was performed except that the following zinc oxide paste was applied by spraying and dried after the formation of the intermediate layer to prepare a metal oxide layer without performing the formation of the composite layer by electrolytic deposition and the desorption of eosin Y, and that the metal oxide layer was not heat treated. As a result, an electrode for photoelectric conversion elements of Comparative Example 3 was obtained.

<Zinc Oxide Paste Composition>

Product name: SUMICEFINE (manufactured by Sumitomo Osaka Cement Co., Ltd., an average particle diameter of 10 to 30 nm, toluene solvent).

(Comparative Example 4)

The electrode for photoelectric conversion elements of Comparative Example 3 was left for 30 minutes in a heater (in air, under atmospheric pressure) set to 380˚C in order to heat treat the metal oxide layer, thereby obtaining an electrode for photoelectric conversion elements of Comparative Example 4.

[Orientation Evaluation]

The electrodes for photoelectric conversion elements of Example 3 and Comparative Example 1 were measured using an X-ray diffraction apparatus (product name: MXP18A, manufactured by Mac Science Co., Ltd.). Measurement

conditions were a radiation source of Cu and a 2θ scan range of 20 to 70˚. FIG. 3 shows measurement results. A peak intensity ratio $I_{002}/I_{101}$ was calculated from a peak intensity of a (002) face of 2θ≈34.4˚ and a peak intensity of a (101) face of 2θ≈36.2˚ in the obtained profile data, in order to evaluate an orientation of zinc oxide. As a result, the peak intensity ratio $I_{002}/I_{101}$ was 10.8. As reference data, X-ray diffraction measurement of polycrystalline zinc oxide in powder form (manufactured by Kanto Chemical Co., Inc.) was conducted in the same way to calculate a peak intensity ratio $I_{002}/I_{101}$. The calculated peak intensity ratio $I_{002}/I_{101}$ was 0.44. From the results shown in FIG. 3, it has been confirmed that the electrode for photoelectric conversion elements of Example 1 and Comparative Example 1 both exhibit a sharp diffraction peak as derived from zinc oxide, and have high crystallinity as a bulk property with a controlled c-axis orientation. It has also been confirmed that an X-ray diffraction profile hardly changes depending on whether or not the metal oxide layer is heat treated.

[Structural Evaluation]

Sections of the electrodes for photoelectric conversion elements of Examples 1 to 4 and Comparative Examples 1 to 4 were observed using an electron microscope. As representative views, FIG. 4 shows a sectional SEM photograph of the electrode for photoelectric conversion elements of Example 1, and FIG. 5 shows a sectional SEM photograph of the electrode for photoelectric conversion elements of Comparative Example 3. It has been confirmed that the metal oxide layers of the electrodes for photoelectric conversion elements of Examples 1 to 4 and Comparative Examples 1 and 2 are each a structure having a plurality of raised portions referred to as bump-like protrusions (see FIG. 4) formed so as to protrude radially from the base side, where the plurality of bump-like protrusions form a concavo-convex surface. On the other hand, no such bump-like protrusions were found in the metal oxide layers of the electrodes for photoelectric conversion elements of Comparative Examples 3 and 4 (see FIG. 5).

[Cathodoluminescence Measurement]

Cathodoluminescence measurement was performed on the electrodes for photoelectric conversion elements of Examples 1 to 4 and Comparative Examples 1 to 4, using an electron probe microanalyzer (product name: EPMA-1600, manufactured by Shimadzu Corporation). Measurement conditions were an acceleration voltage of 15 kV, a beam current of 50 nA, and a beam diameter of 100 μm. FIGS. 6 and 7 show measurement results. From the results shown in FIG. 6, it has been confirmed that an emission peak appears near 380 nm as derived from a band gap of zinc oxide, by performing a heat treatment of 220˚C or more on the metal oxide layer. Given that there is no emission peak near 380 nm in Comparative Example 1 which is not heat treated, it is suggested that the metal oxide layer formed by electrolytic deposition has high crystallinity as a whole bulk (see FIG. 3) but also has many crystal defects such as oxygen defects on its surface. Moreover, from the results shown in FIG. 6, it has been confirmed that the emission intensity in the visible light region (400 to 700 nm) is smaller and the emission intensity near 380 nm is larger when the heat treatment temperature of the metal oxide layer is higher. Given that there is almost no change in X-ray diffraction profile depending on whether or not the metal oxide layer is heat treated (see FIG. 3), it is suggested that a higher heat treatment temperature of the metal oxide layer enables more crystal defects such as oxygen defects on the surface to be reduced. On the other hand, from the results shown in FIG. 7, it has been confirmed that the electrode prepared by spraying the zinc oxide paste has an emission peak near 380 nm and in the visible light region.

[Cell Evaluation]

A dye-sensitized solar cell having the same structure as the dye-sensitized solar cell 31 shown in FIG. 2 was manufactured according to the following procedure. First, each of the metal oxide layers of the electrodes for photoelectric conversion elements of Examples 1 to 4 and Comparative Examples 1 to 4 was immersed for two hours in a dye containing solution (an acetonitrile solution with 0.15 mM of a cyanine dye represented by the following formula) to re-adsorb the dye to the metal oxide layer, and then washed and dried to thereby obtain working electrodes (photoelectric conversion elements (electrodes)) of Examples 1 to 4 and Comparative Examples 1 to 4.

[Formula]

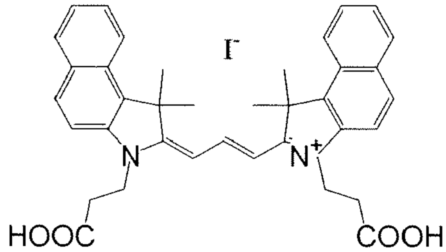

Next, using an electrode obtained by forming a Pt thin film of 100 nm by sputtering on a transparent glass substrate (TCO: manufactured by Asahi Glass Co., Ltd.) having a transparent conductive film of SnO doped with fluorine as a counter electrode, the counter electrode and each of the working electrodes of Examples 1 to 4 and Comparative Examples 1 to 4 were disposed so as to face each other via a spacer thickness of 50 μm. Following this, a UV curable adhesive was applied around the dye-adsorbed zinc oxide film, and a predetermined amount of methoxypropionitrile solution (iodine: 0.05 M, TPAI (tetrapropyl ammonium iodide): 0.5 M) as a charge transport layer (electrolyte solution) was dropped on the zinc oxide film. The structure was then bonded together under vacuum and further sealed by curing adhesion portions by UV radiation, thereby manufacturing a cell. As a result, dye-sensitized solar cells of Examples 1 to 4 and Comparative Examples 1 to 4 were obtained.

The obtained dye-sensitized solar cells of Examples 1 to 4 and Comparative Examples 1 to 4 were radiated with light having a pseudo-solar spectrum of AM-1.5 5 using a solar simulator, and current-voltage characteristics were measured to thereby measure photoelectric conversion efficiency. The measurement of photoelectric conversion efficiency was conducted twice, namely, immediately after cell manufacture (one hour after cell manufacture) and after reliability testing (after leaving the cell for 250 hours in a constant temperature bath of 85˚C and 85% RH and then allowing the cell to cool in the atmosphere for one hour). A ratio (residual ratio) of the photoelectric conversion efficiency after reliability testing was calculated with reference to the photoelectric conversion efficiency immediately after cell manufacture. A higher residual ratio indicates higher durability. Tables 1 and 2 show evaluation results. In Table 1, a UV emission peak intensity is a maximum intensity of a peak in the region of 350 to 400 nm in cathodoluminescence measurement. In Table 2, initial photoelectric conversion efficiency is shown by relative evaluation based on Example 3.

[Table 1]

| | Comp. Ex. 1 | Comp. Ex. 2 | Ex. 1 | Ex. 2 | Ex. 3 | Ex. 4 |
|---|---|---|---|---|---|---|
| Film formation condition | Electrolytic deposition | | Electrolytic deposition | | | |
| Bump-like protrusion | Exist | Exist | Exist | Exist | Exist | Exist |
| Heat treatment temperature ˚C | None | 150 | 220 | 300 | 380 | 450 |
| UV emission peak intensity a.u. | 0 | 0 | 138 | 167 | 230 | 415 |
| Residual ratio after reliability testing % | 9<br>× | 11<br>× | 68<br>○ | 75<br>○ | 82<br>○ | 85<br>○ |

[Table 2]

| | Comp. Ex. 1 | Comp. Ex. 2 | Ex.1 | Ex. 2 | Ex.3 | Ex.4 | Comp. Ex. 3 | Comp. Ex. 4 |
|---|---|---|---|---|---|---|---|---|
| Film formation condition | Electrolytic deposition | | Electrolytic deposition | | | | Paste application | |
| Bump-like protrusion | Exist | Exist | Exist | Exist | Exist | Exist | None | None |
| Heat treatment temperature ˚C | None | 150 | 220 | 300 | 380 | 450 | None | 380 |

(continued)

| | Comp. Ex. 1 | Comp. Ex. 2 | Ex.1 | Ex. 2 | Ex.3 | Ex.4 | Comp. Ex. 3 | Comp. Ex. 4 |
|---|---|---|---|---|---|---|---|---|
| Film formation condition | Electrolytic deposition | | Electrolytic deposition | | | | Paste application | |
| Initial photoelectric conversion efficiency | 1.04<br>○ | 1.03<br>○ | 0.99<br>○ | 0.97<br>○ | 1.00<br>○ | 0.94<br>○ | 0.48<br>× | 0.67<br>× |
| Residual ratio after reliability testing % | 9<br>× | 11<br>× | 68<br>○ | 75<br>○ | 82<br>○ | 85<br>○ | 75<br>○ | 48<br>○ |

From the results shown in Tables 1 and 2, it has been confirmed that, though Examples 1 to 4 which use the electrode for photoelectric conversion elements including the metal oxide layer having an emission peak in the region of 350 to 400 nm in cathodoluminescence measurement have similar photoelectric conversion efficiency immediately after cell manufacture to Comparative Examples 1 and 2, Examples 1 to 4 exhibit significant improvements in residual ratio after reliability testing as compared with Comparative Examples 1 and 2 and therefore have excellent durability. It has also been confirmed that a higher heat treatment temperature contributes to a higher residual ratio after reliability testing. Moreover, it has been confirmed that Comparative Examples 3 and 4 in which the metal oxide layer is formed using the zinc oxide paste have a favorable residual ratio, but exhibit significantly low photoelectric conversion efficiency immediately after cell manufacture as compared with Examples 1 to 4 and therefore have poor initial characteristics.

As noted earlier, the present invention is not limited to the above embodiments and examples, and can appropriately be modified within the scope of the present invention.

As described above, the electrode for photoelectric conversion elements, the manufacturing method of the electrode for photoelectric conversion elements, and the dye-sensitized solar cell according to the present invention exhibit not only excellent initial characteristics but also excellent durability and further achieve improved productivity and economic efficiency, and therefore can be widely and effectively used in electronic and electrical materials and electronic and electrical devices having various electrodes and/or photoelectric conversion elements, and various apparatuses, facilities, systems, and the like including such electronic and electrical materials and electronic and electrical devices.
The present application is based on Japanese priority application No. 2009-080924 filed on March 30, 2009, the entire contents of which are hereby incorporated by reference.

[NUMERICAL REFERENCES]

11: electrode for photoelectric conversion elements
12: base
12a: conductive surface
13: intermediate layer
14: metal oxide layer
14a: bump-like protrusion
31: dye-sensitized solar cell (solar cell)
32: working electrode (photoelectric conversion element (electrode))
33: counter electrode
33a: conductive surface
34: charge transport layer

## Claims

**1.** An electrode for photoelectric conversion elements comprising:

a base; and
a metal oxide layer containing zinc oxide,
wherein the metal oxide layer has a plurality of bump-like protrusions formed so as to protrude radially from a side of the base, and also has an emission peak in a region of 350 to 400 nm in cathodoluminescence measurement.

**2.** The electrode for photoelectric conversion elements according to Claim 1, wherein the metal oxide layer is heat treated at 220 to 500°C.

**3.** The electrode for photoelectric conversion elements according to Claim 1 or 2, wherein the metal oxide layer satisfies a relation defined by the following formula (1)

$$2 \leq I_{002}/I_{101} \qquad \cdots (1)$$

wherein $I_{002}$ denotes a peak intensity attributed to a zinc oxide (002) face in X-ray diffraction measurement, and $I_{101}$ denotes a peak intensity attributed to a zinc oxide (101) face in X-ray diffraction measurement.

**4.** The electrode for photoelectric conversion elements according to any one of Claims 1 to 3, wherein the metal oxide layer is heat treated after being formed by electrolytic deposition.

**5.** A dye-sensitized solar cell comprising:

a working electrode in which a dye is carried by the electrode for photoelectric conversion elements according to any one of Claims 1 to 4;
a counter electrode disposed so as to face the working electrode; and
a charge transport layer disposed between the working electrode and the counter electrode.

**6.** A manufacturing method of an electrode for photoelectric conversion elements, comprising:

a step of preparing an electrode in which a metal oxide layer containing zinc oxide is provided on a base, the metal oxide layer having bump-like protrusions formed so as to protrude radially from a side of the base; and
a step of heat treating the metal oxide layer at 220 to 500°C to form the metal oxide layer having an emission peak in a region of 350 to 400 nm in cathodoluminescence measurement.

**7.** The manufacturing method of the electrode for photoelectric conversion elements according to Claim 6, wherein in the step of preparing the electrode, the base and a counter electrode are disposed so as to face each other in an electrolyte solution of a dye concentration of 50 to 500 μM containing zinc salt and a first dye and a voltage of -0.8 to -1.2 V (vs. Ag/AgCl) is applied between the base and the counter electrode to form a composite layer in which the dye is co-adsorbed to zinc oxide, and subsequently the dye is desorbed from the composite layer, thereby forming the metal oxide layer.

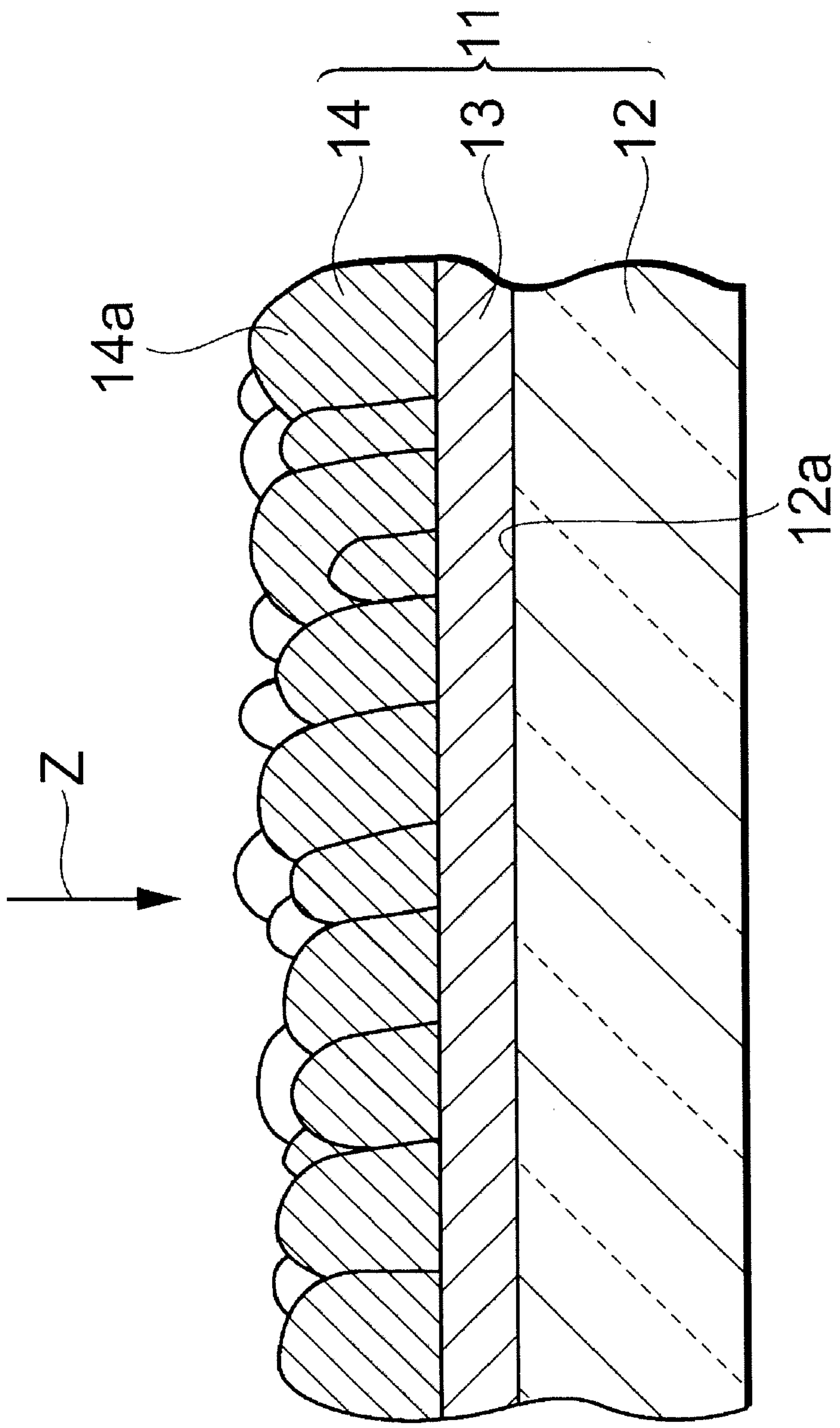


*FIG. 1*

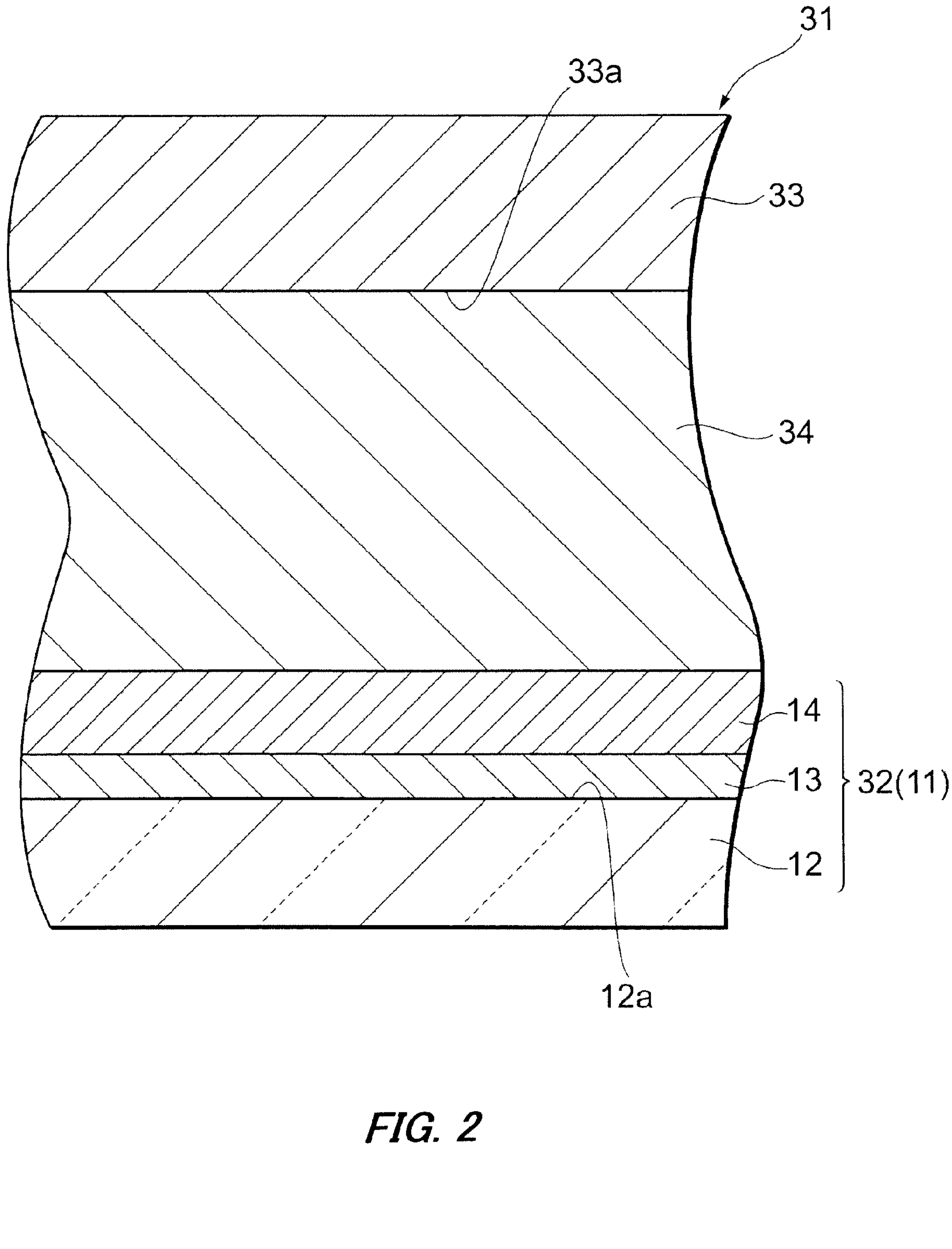


*FIG. 2*

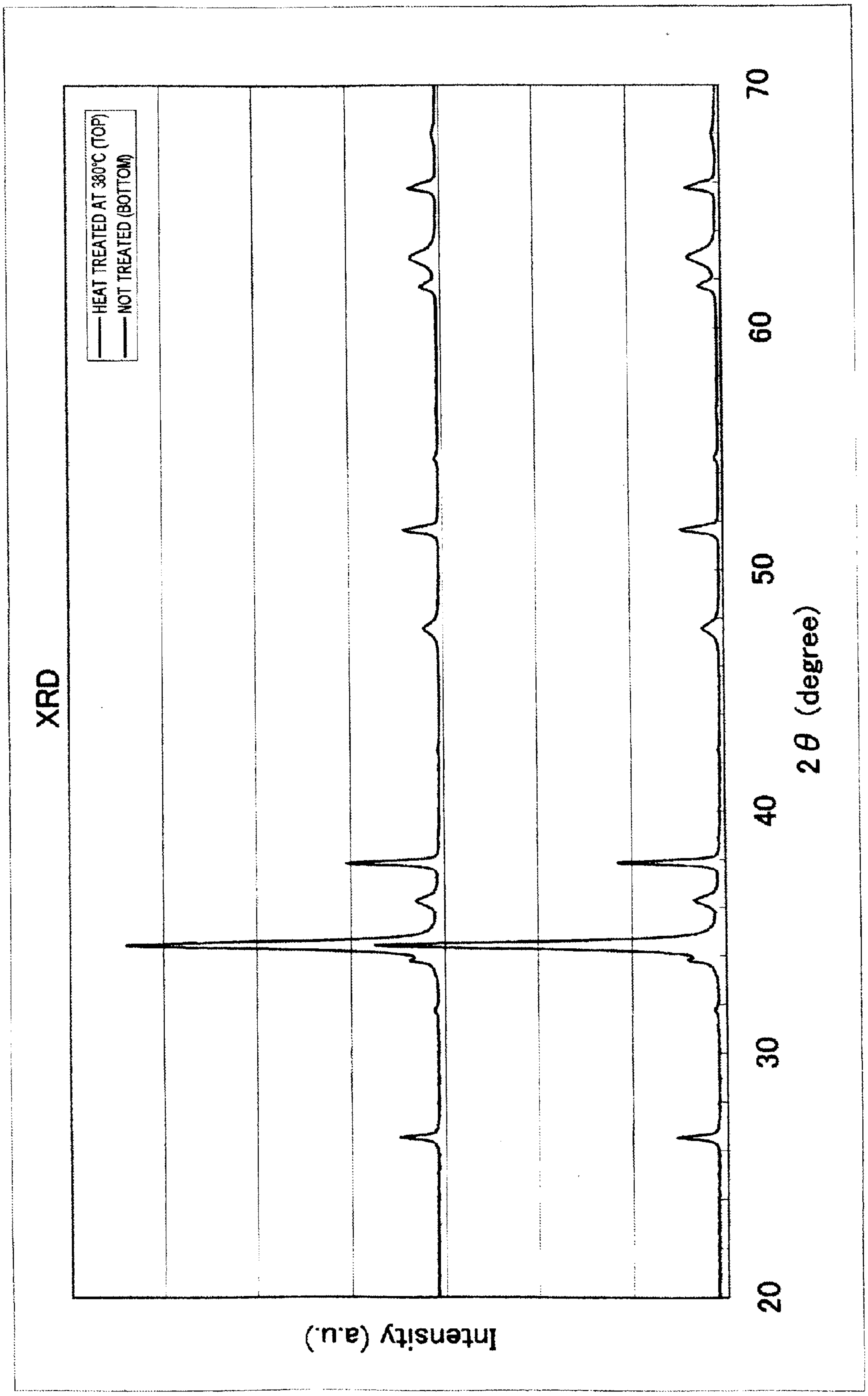
XRD
HEAT TREATED AT 380°C (TOP)
NOT TREATED (BOTTOM)
Intensity (a.u.)
2θ (degree)
20
30
40
50
60
70

*FIG. 3*

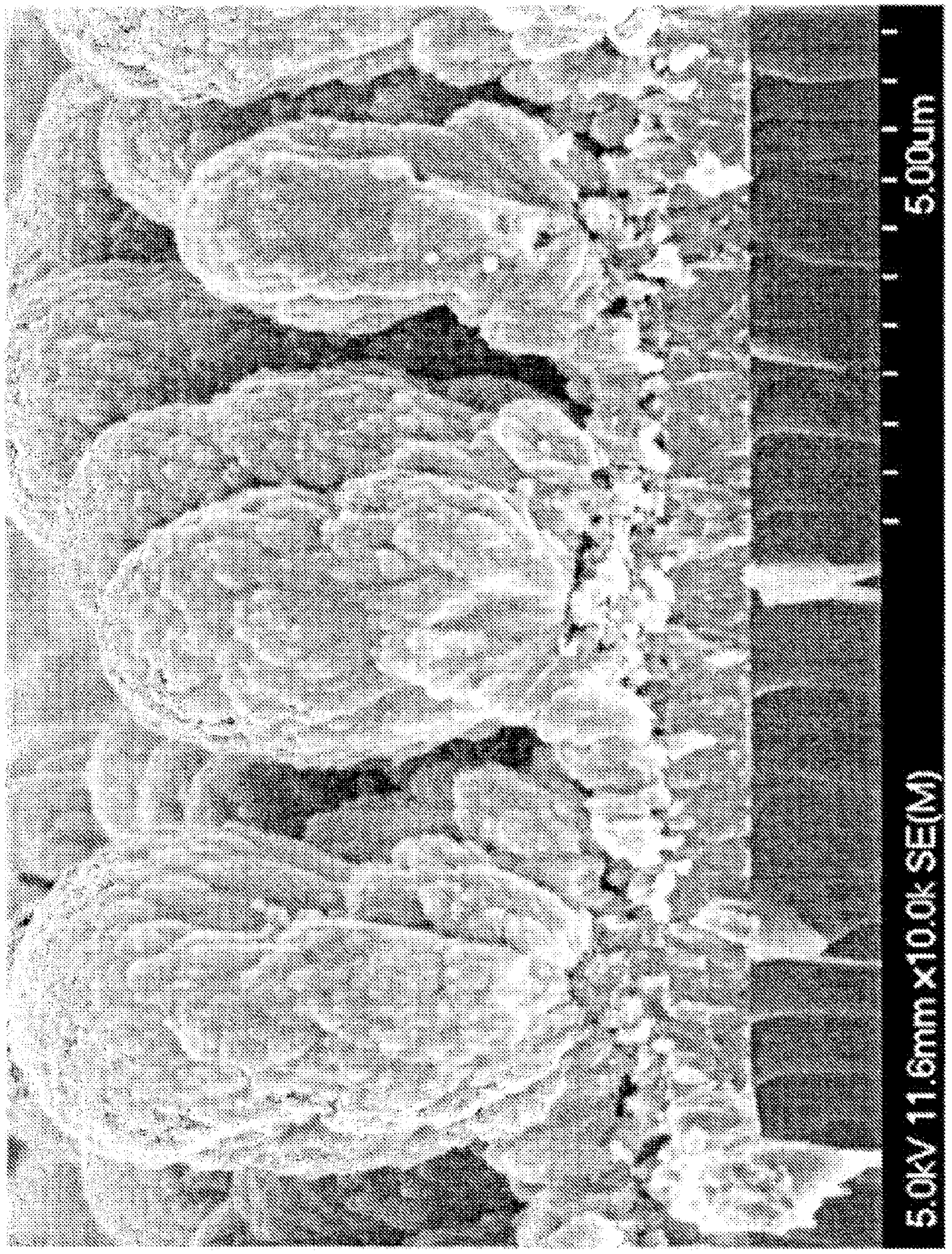


FIG. 4

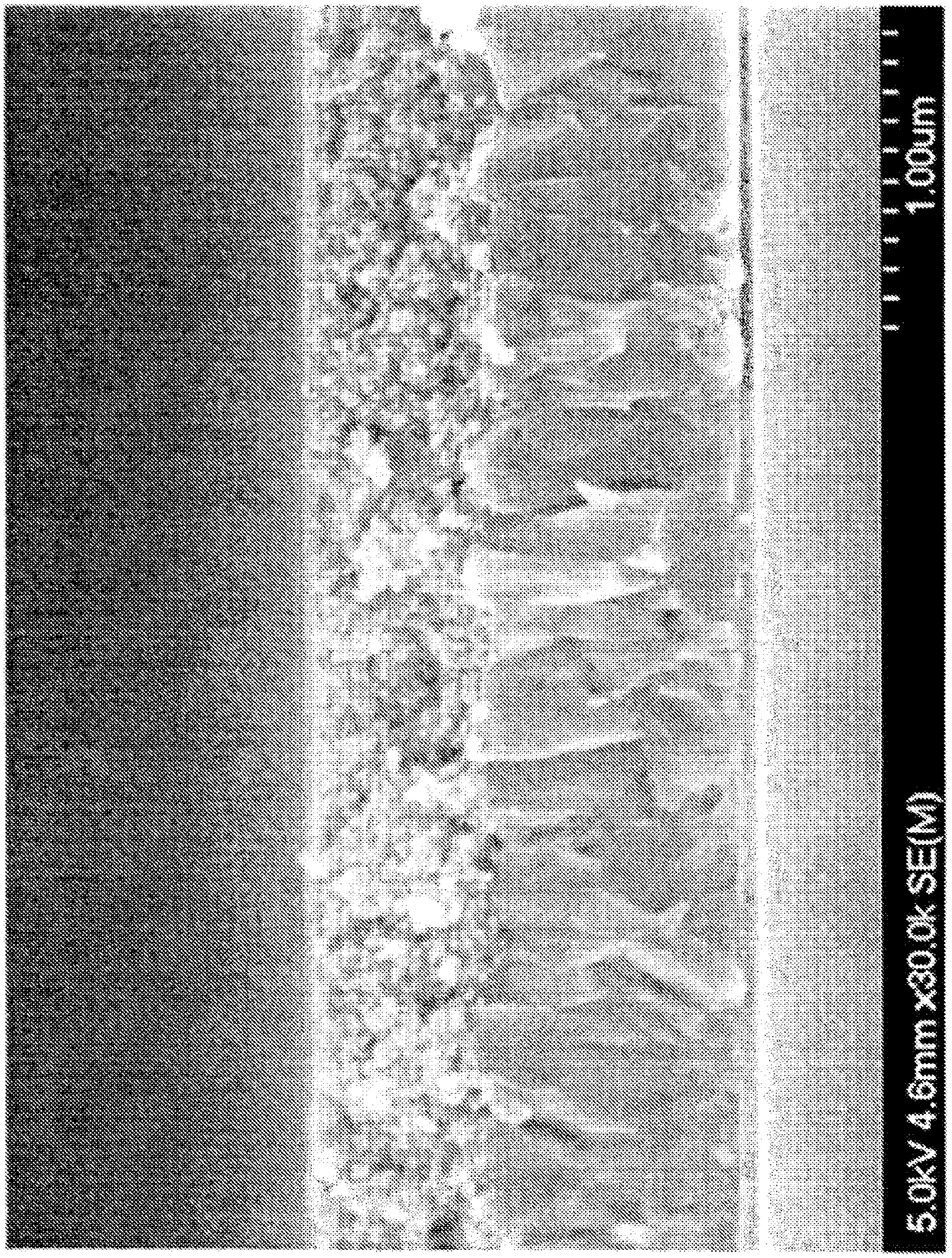


FIG. 5

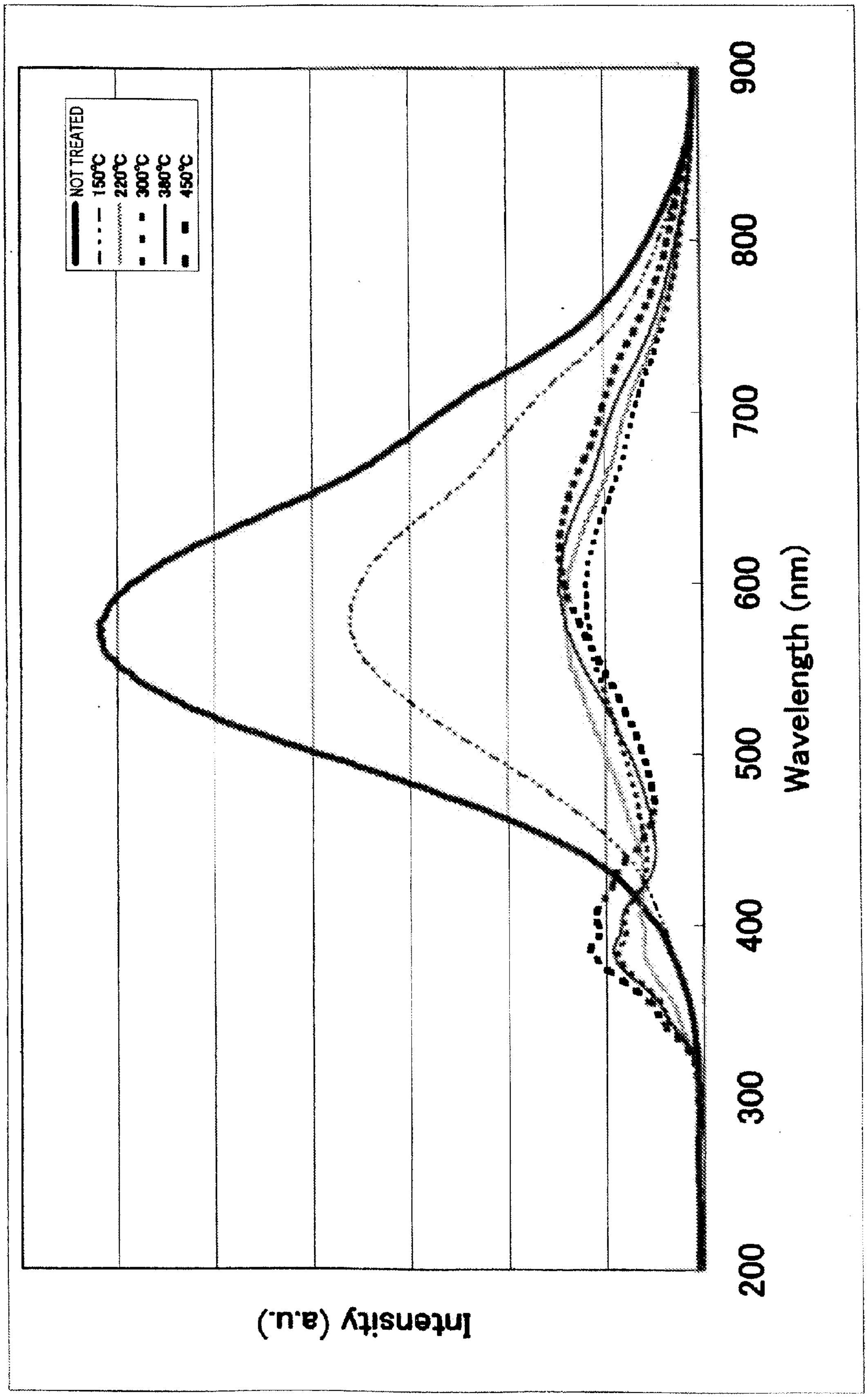
NOT TREATED
150°C
220°C
300°C
380°C
450°C
Intensity (a.u.)
200
300
400
500
600
700
800
900
Wavelength (nm)

FIG. 6

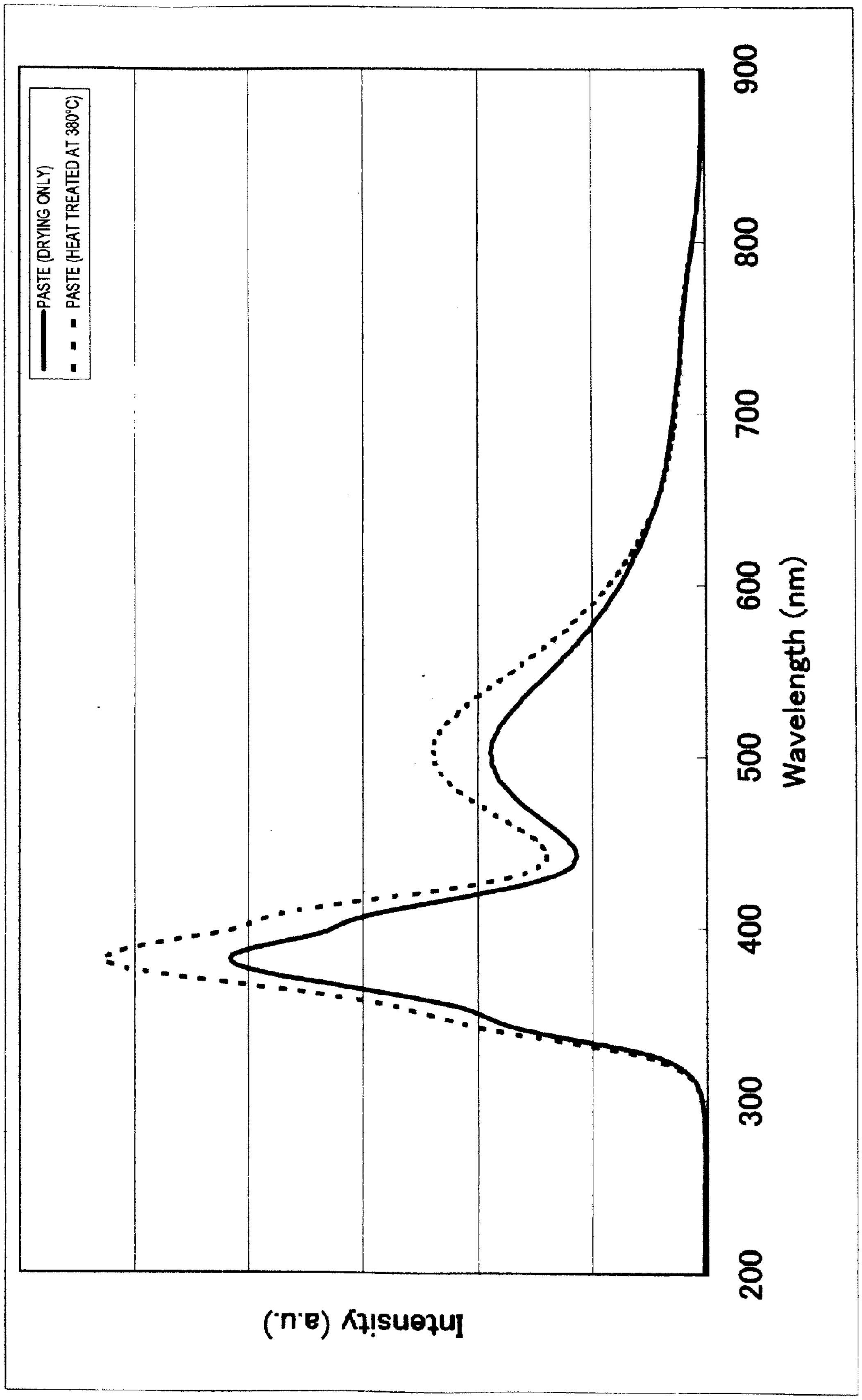
PASTE (DRYING ONLY)
PASTE (HEAT TREATED AT 380°C)
Intensity (a.u.)
200
300
400
500
600
700
800
900
Wavelength (nm)

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2002184476 A
- JP 2004006235 A
- JP 2003217689 A
- JP 2008230895 A
- JP 2009080924 A